Europäisches Patentamt

European Patent Office

Office européen des brevets

(19)

(11) **EP 0 710 300 B1**

(12) **EUROPÄISCHE PATENTSCHRIFT**

(45) Veröffentlichungstag und Bekanntmachung des Hinweises auf die Patenterteilung:
**11.06.1997 Patentblatt 1997/24**

(21) Anmeldenummer: **94924238.2**

(22) Anmeldetag: **06.07.1994**

(51) Int Cl.⁶: **C30B 29/22**, H01L 39/12, H01L 39/24

(86) Internationale Anmeldenummer:
**PCT/EP94/02206**

(87) Internationale Veröffentlichungsnummer:
**WO 95/02717 (26.01.1995 Gazette 1995/05)**

(54) **HOCHTEMPERATURSUPRALEITENDE MASSIVKÖRPER UND VERFAHREN ZU IHRER HERSTELLUNG**

SOLID BODY WHICH IS SUPERCONDUCTING AT HIGH TEMPERATURES AND METHOD OF PRODUCING SUCH A BODY

CORPS MASSIFS SUPRACONDUCTEURS A HAUTE TEMPERATURE ET LEUR PROCEDE DE FABRICATION

(84) Benannte Vertragsstaaten:
**CH DE FR GB IT LI**

(30) Priorität: **17.07.1993 DE 4324088**

(43) Veröffentlichungstag der Anmeldung:
**08.05.1996 Patentblatt 1996/19**

(73) Patentinhaber: **HOECHST AKTIENGESELLSCHAFT
65929 Frankfurt am Main (DE)**

(72) Erfinder:
- **BRAND, Markus
  D-65817 Eppstein (DE)**
- **BROMMER, Günter
  D-65185 Wiesbaden (DE)**
- **ELSCHNER, Steffen
  D-65527 Niedernhausen (DE)**
- **GAUSS, Stephan
  D-65843 Sulzbach (DE)**
- **ASSMUS, Wolf
  D-63452 Hanau (DE)**

(56) Entgegenhaltungen:
- **PATENT ABSTRACTS OF JAPAN, unexamined applications, C field, Band 17, Nr. 285, 02 Juni 1993, The Patent Office Japanese Govt.; Seite 142 C 1066**
- **CHEMICAL ABSTRACTS, Band 117, Nr. 22, 30 November 1992, Columbus, OH (US); P. McGINN et al., Seite 839, AN 224021e**
- **CHEMICAL ABSTRACTS, Band 118, Nr. 4, 25 Jänner 1993, Columbus, OH (US); A.M. BALBASHOV et al., Seite 623, AN 30969v**
- **CHEMICAL ABSTRACTS, Band 113, Nr. 8, 20 August 1990, Columbus, OH (US); D. SHI et al., Seite 692, AN 69342g**
- **CHEMICAL ABSTRACTS, Band 119, Nr. 26, 18 Okfober 1993, Columbus, OH (US); Y. ISHIKAWA et al., Seite 851, AN 172247c**
- **CHEMICAL ABSTRACTS, Band 120, Nr. 26, 18 April 1994, Columbus, OH (US); C. VARANISI et al., Seite 1092, AN 206119a**
- **CHEMICAL ABSTRACTS, Band 120, Nr. 26, 27 Juni 1994, Columbus, OH (US); H.S. GAMCHI et al., Seite 924, AN 336305u**

**Beschreibung**

Die vorliegende Erfindung betrifft ein Verfahren zur Herstellung von hochtemperatursupraleitenden Massivteilen mit Textur.

Oxidkeramische Hochtemperatursupraleiter gelten als aussichtsreiche Materialien für Bauteile oder Werkstücke im Bereich der Elektrotechnik und Elektronik, da ihre hohen Sprungtemperaturen einen Betrieb in flüssigem Stickstoff ermöglichen und eine Kühlung mit flüssigem Helium nicht erforderlich ist. Voraussetzung für ihre breite wirtschaftliche Anwendung ist aber eine hohe kritische Stromdichte $j_c$.

Es gibt bereits Verfahren zur Herstellung von supraleitenden Bauteilen mit hohen kritischen Stromdichten. So können supraleitende Schichten der Verbindungen $YBa_2Cu_3O_x$ (YBCO 123) und $Bi_2Sr_2CaCu_2O_x$ (BSCCO 2212) auf einkristallinen Substraten aus $SrTiO_3$ oder MgO abgeschieden werden und ermöglichen dort Stromdichten $j_c$ von $\geq 10^6$ A/cm². Die so erhaltenen Bauteile haben aber den Nachteil begrenzter Leiterlänge und geringer absoluter Ströme. Bei der "Pulver in Rohr"-Methode werden ebenfalls hohe Stromdichten im Bereich von $\geq 5 \cdot 10^4$ A/cm² erreicht. Dieses Verfahren ist mit Verbindungen des Types BSCCO 2212 beziehungsweise BSCCO 2223 erfolgreich durchgeführt worden (siehe B. Hensel et al. in Physica C 205 (1993) 329-337). Die resultierenden Proben haben ebenfalls nur verhältnismäßig geringe absolute Ströme und tragen zusätzlich unvermeidbar einen Silbermantel um die supraleitende Seele. Für eine Reihe von technischen Anwendungen wie Stromzuführungen oder Strombegrenzer ist dieser Silbermantel nicht erwünscht oder störend.

Bei der Herstellung von Bauteilen nach den in der technischen Keramik herkömmlichen Formgebungsverfahren erreicht man aber bisher nur geringe kritische Transportstromdichten von nicht über 1000 A/cm². Verantwortlich dafür ist die schlechte Kopplung ("weak links") zwischen den einzelnen supraleitenden Körnern. Im Rahmen der Erfindung wird als c-Achse die kristallographische Achse senkrecht zu den CuO-Ebenen in den supraleitenden Kristallen bezeichnet, während mit a und b die Achsen in den CuO-Ebenen bezeichnet werden. Nach den Untersuchungen von Dimos et al. in Physical Review B, Vol. 41, (1990), 4038-4049, hängt die kritische Transportstromdichte in oxidkeramischem supraleitendem Material der Substanzklasse YBCO empfindlich von den Winkeln zwischen den kristallographischen Achsen einzelner Kristallite ab. Je kleiner die Winkel, desto größer die kritische Transportstromdichte. Am günstigsten ist eine sogenannte »zwei-Achsen-Textur«, d.h. die jeweiligen kristallographischen Achsen aller Kristallite liegen parallel zueinander bei gleichzeitiger Ausrichtung der (a,b)-Ebenen längs der supraleitenden Stromrichtung.

Aufgabe der vorliegenden Erfindung war es daher, eine geeignetes Verfahren bereitzustellen, mit dem sich die Kristallite eines Bauteils möglichst parallel zueinander und längs der Stromrichtung orientieren lassen und mit dem sich somit massive Formteile aus oxidkeramischem supraleitenden Material herstellen lassen, die kritische Transportstromdichten von mehr als 10 000 A/cm² ermöglichen.

Diese Aufgabe wird gelöst durch ein Verfahren der eingangs genannten Gattung, dessen kennzeichende Merkmale darin zu sehen sind, daß massive Formteile aus oxidkeramischem supraleitendem Material eines Phasengemisches der Substanzklasse YBCO zunächst geformt, gepreßt und gesintert werden, daß dann entlang ihrer Längsachse eine zonenweise thermische Behandlung erfolgt, wobei in einer ersten Zone zunächst auf eine Temperatur im Bereich von 50 bis 200 K unterhalb der peritektischen Schmelztemperatur des in dem Formteil vorgegebenen Phasengemisches erhitzt wird, wobei danach in einer zweiten Zone mit einem Temperaturgradienten im Bereich von 10 bis 250 K/cm die Temperatur heraufgesetzt wird, wobei danach in einer dritten Zone eine Temperatur von bis zu 50 K oberhalb der peritektischen Schmelztemperatur des in dem Formteil vorgegebenen Phasengemisches gehalten wird, wobei danach in einer vierten Zone mit einem Temperaturgradienten im Bereich von 10 bis 250 K/cm abgekühlt wird und wobei abschließend in einer fünften Zone eine Temperatur im Bereich von 50 bis 200 K unterhalb der peritektischen Schmelztemperatur des in dem Formteil vorgegebenen Phasengemisches eingehalten wird, und daß die Zonen mit einer Geschwindigkeit im Bereich von 1 bis 10 mm/h in Längsrichtung fortbewegt werden.

Erfindungsgemäß hergestellte Formteile besitzen bevorzugt die Geometrie von Stäben mit einer Länge von bis zu 1 m und einem Durchmesser im Bereich von 1 bis 50 mm. Das Ausgangsmaterial für die Stäbe ist vorzugsweise eine Mischung von YBCO 123 mit 12 bis 28 Mol-% YBCO 211, bezogen auf die Gesamtmolmenge an supraleitendem Material. Günstig ist eine feine Verteilung der Zusätze an YBCO 211 mit einem mittleren Teilchendurchmesser von $\leq 1$ µm. Die zusätzliche Zugabe von $PtO_2$ in einer Menge von 0,5 bis 10 Mol-%, bezogen auf die Gesamtmolmenge an supraleitendem Material, in feiner Verteilung mit einem mittleren Teilchendurchmesser von < 50 µm verhindert eine unerwünschte Kragenbildung auf der Seite des gesinterten Ausgangsmaterials während der zonenweisen thermischen Behandlung. $PtO_2$ ist reinem Pt vorzuziehen, weil über das Oxid eine feinere Verteilung des Metalls im Ausgangsmaterial gelingt.

Die zunächst bis zu einer Dichte von 90 %, vorzugsweise bis 92 %, der theoretisch möglichen Dichte gesinterten Stäbe werden zur Durchführung des erfindungsgemäßen Verfahrens längs auf einen Keramikstab montiert und in einen Zonenschmelzofen mit 5 unabhängig voneinander einstellbaren Temperaturzonen (I bis V) gebracht. Die Temperaturen in den verschiedenen Zonen werden so eingestellt, daß in Zone III (heiße Zone) eine Temperatur knapp oberhalb und in den Zonen I und V Temperaturen unterhalb der peritektischen Schmelztemperatur des in dem Sinterformteil vorgegebenen Phasengemisches herrschen. Die peritektischen Schmelztemperaturen von Gemischen der erfindungsgemäß bevorzugten Zusammensetzung liegen normalerweise im Bereich von 950 bis 1050°C. In den Zonen II und IV wird ein steiler Temperaturgradient von vorzugsweise 100 bis 250 K/cm eingestellt. Das Formteil wird zunächst so in dem Ofen positioniert, daß sich sein eines Ende In der heißen Zone befindet und partiell aufschmilzt. Anschließend wird das Formteil langsam durch die heiße Zone hindurchgezogen. Bei der erfindungsgemäßen Ausführung des Verfahrens zeigt sich, daß derjenige Teil der Probe, welcher die heiße Zone bereits durchlaufen hat, hochgradig texturiert ist, d.h. die kristallographischen Achsen der Kristallite in dem Formteil sind parallel zueinander ausgerichtet.

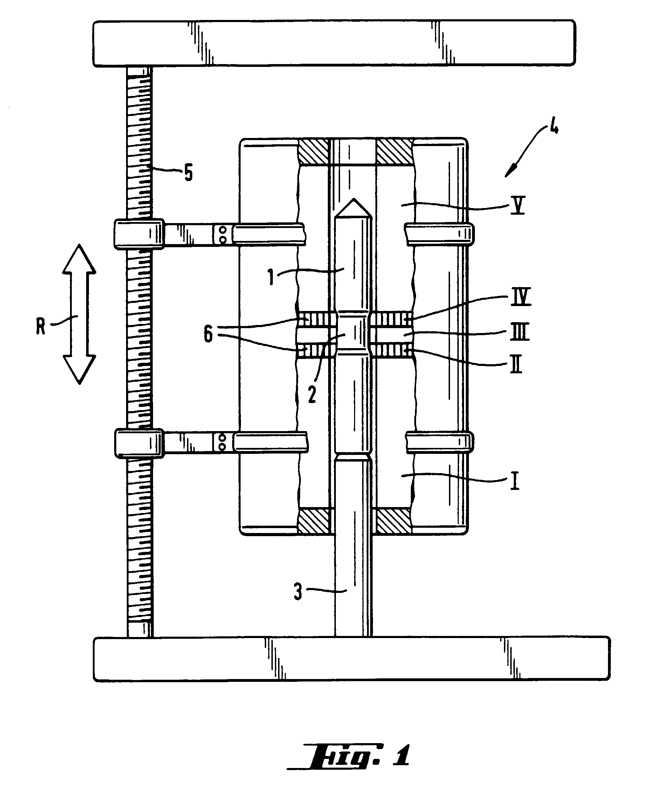

Die Figur 1 zeigt eine schematische Darstellung eines Zonenschmelzofens, wie er typischerweise zur Durchführung des erfindungsgemäßen Verfahrens geeignet ist. Mit Bezugszeichen sind das Formteil 1, die Schmelzzone 2 und der Probenhalter 3 verdeutlicht. Der Zonenschmelzofen selbst 4 ist an einer Halterung 5 beweglich in die Bewegungsrichtung R angebracht. Der Temperaturgradiens in den Zonen II und IV läßt sich mit Hilfe von Kühlblechen 6 einstellen, die aus besonders wärmeleitfähigen Legierungen gefertigt sind.

Nach dem erfindungsgemäßen Verfahren hergestellte Formteile sind bereits mit einer hohen kritischen Transportstromdichte von 13 000 A/cm$^2$ belastbar. Allerdings zeigt sich, daß die Richtung der parallel ausgerichteten (a,b)-Ebenen noch nicht unbedingt die optimale Orientierung parallel zur vorgesehenen Stromrichtung, d.h. parallel zur Stabachse besitzt. Bei der vorstehend erläuterten Durchführung des erfindungsgemäßen Verfahrens ergibt sich stets ein Winkel zwischen Stabachse und den parallel zueinander angeordneten c-Achsen der Kristallite vor 55°. Das bedeutet, daß der Winkel zwischen den (a,b)-Ebenen der Kristallite und der Stabachse gleich 90° - 55° = 35° ist. Dieses ist eine Folge der isotropen Wärmeleitfähigkeit innerhalb der sich bildenden Kristallite, wobei auch der radiale Temperaturgradient des Ofens zu berücksichtigen ist. Es wurden überraschend zwei unabhängige Verfahren gefunden, mit denen jeweils auch die optimale Orientierung der parallel zueinander angeordneten (a,b)-Ebenen der Kristallite zur Flußrichtung des Stromes in Stablängsrichtung erreicht wird. Dem entspricht ein Winkel zwischen den c-Achsen und der Stabachse von 90°.

Nach der ersten Verfahrensvariante wird im oben beschriebenen Verfahren zunächst das eine Ende der Probe in die heiße Zone gebracht. Anschließend wird die Probe durch die heiße Zone gezogen. Zunächst bilden sich eine große Zahl unabhängig orientierter Keime. Durch natürliche Keimauslese setzt sich einer dieser Keime durch, normalerweise der mit der 55°-Orientierung. Bereits nach wenigen cm ist die Probe diesem Keim entsprechend texturiert. Um die natürliche Keimauslese, die offenbar stets zu der 55°-Orientierung führt, zu verhindern, wird der zu behandelnde Stab vorher angespitzt und auf der Spitze wird ein kleiner Einkristall in der gewünschten Orientierung befestigt. Die Probe wird nun so in die heiße Zone des Ofens gebracht, daß es zu einem teilweisen Aufschmelzen des Impfkristalls kommt. Dieser gibt dann als künstlicher Keim die Orientierung der Textur vor.

Nach der zweiten Verfahrensvariante wird der Temperaturgradient zwischen der heißen Zone und dem texturierten Teil der Probe schräg zur Probenachse orientiert. Dies kann beispielsweise durch entsprechende Anordnung, z.B. Schrägstellung, der für die Einstellung des Temperaturgradienten in Längsrichtung verantwortlichen Kühlbleche geschehen. Der entsprechende Winkel sei mit $\varphi$ ($0° < \varphi < 90°$) bezeichnet.

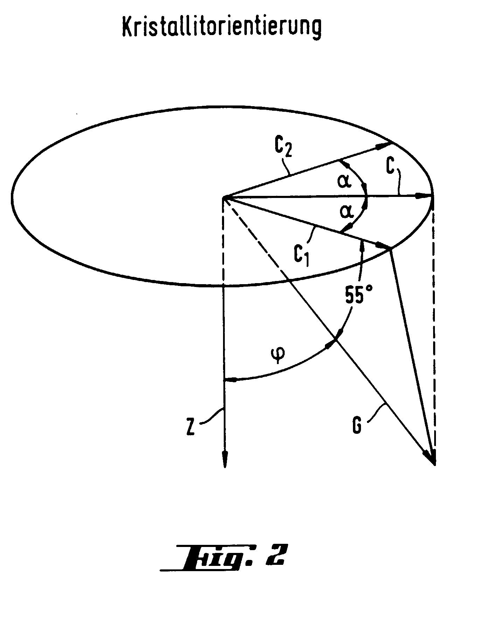

Die Figur 2 veranschaulicht die Kristallitorientierung für den Fachmann noch deutlicher. Mit Bezugszeichen sind die Stabachse Z und die Richtung des Temperaturgradienten G hervorgehoben, die zwischen sich den Winkel $\varphi$ bilden, während $c_1$ und $c_2$ mögliche Richtungen der c-Achsen der Kristallite sind, die zwischen der punktiert dargestellten Projektion des Temperaturgradienten auf die waagrechte Ebene die Winkel $\alpha$ bilden.

Bezüglich des orientierten neuen Temperaturgradienten bildet sich ebenfalls eine Textur mit dem Winkel $\varphi = 55°$ zwischen kristallographischer c-Achse und Temperaturgradient aus. Angestrebt wird ein Winkel zwischen Stabachse und c-Achse der Kristallite von 90°. Durch geeignete Wahl der Winkel sowohl zwischen Stabachse und Temperaturgradient als auch zwischen c-Achse des Keims und Temperaturgradient kann erreicht werden, daß beide Bedingungen simultan erfüllt sind. In diesem Fall wird dann zuverlässig erreicht, daß die Probe in optimaler Weise texturiert ist.

Im folgenden wird beschrieben, wie die entsprechenden Winkel vorzugsweise zu wählen sind: Zunächst wird der Winkel $\varphi$ zwischen Stabachse und Temperaturgradient vorgegeben. Die einzige Bedingung besteht darin, daß $\varphi \geq 35°$ sein muß. Bezüglich des so gedrehten Temperaturgradienten nimmt die kristallographische c-Achse des texturierten Materials spontan den charakteristischen Winkel von 55° an. Die c-Achse befindet sich somit auf einem Kegelmantel um die Richtung des Temperaturgradienten mit der Öffnung 55°. Für Winkel $\delta > 35°$ gibt es jeweils zwei Orientierungen auf dem Kegelmantel für die der Winkel zwischen c-Achse und Stabachse wie angestrebt gleich 90° ist. In Figur 2 sind diese beiden Orientierungen mit $c_1$ und $c_2$ bezeichnet. Eine einfache geometrische Überlegung zeigt, daß dies dann der Fall ist, wenn der Winkel $\alpha$ zwischen c-Achse und Projektion des Temperaturgradienten auf die Waagerechte gegeben ist durch die Formel:

$$\cos \alpha = \pm \cos 55°/\sin \varphi.$$

Der Keim muß nun bezüglich des Temperaturgradienten so orientiert werden, daß seine c-Achse einer dieser beiden Richtungen entspricht. Dann sind beide oben erwähnten Bedingungen simultan erfüllt. Im Grenzfall, wenn $\varphi = 35°$, wird $\alpha = 0$. Für $\varphi < 35°$ sind die beiden Bedingungen, daß der Winkel zwischen der c-Achse und der Stabachse gleich 90° und der Winkel zwischen der c-Achse und dem Temperaturgradienten G gleich 55° ist, nicht simultan zu erfüllen.

Nach diesem Verfahren hergestellte Proben haben zuverlässig die korrekte Orientierung.

Die Erfindung soll nachfolgend durch Ausführungsbeispiele für den Fachmann noch deutlicher beschrieben werden, ohne jedoch auf die konkret dargestellten Ausführungsformen beschränkt zu sein.

**Beispiel 1:**

Ausgehend von einer Pulvermischung aus YBCO 123, YBCO 211, $PtO_2$ im molaren Verhältnis 100:20:3 wurde ein zylinderförmiger Rohling mit einer Länge von 10 cm und einem Durchmesser von 8 mm zunächst gepreßt und dann bis zu einer Dichte von 90 % der theoretisch möglichen Dichte gesintert. Anschließend wurde der Stab auf einem Keramikrohr befestigt und in den im Zusammenhang mit Figur 1 beschriebenen Fünfzonenofen gebracht. Das obere Ende des Rohlings befand sich in der heißen Zone. Die Temperatur der Zonen 1 und V wurden auf 800°C gebracht, d.h. 170 K unterhalb der peritektischen Schmelztemperatur. Zone III hingegen lag mit 1020°C oberhalb dieser Temperatur, so daß das Material partiell aufschmolz. Der Temperaturgradient in Zone IV wurde auf 140 K/cm eingestellt. Anschließend wurde die Probe mit einer Geschwindigkeit von 1 mm/h durch die heiße Zone gezogen. Im oberen Teil des Stabes bildeten sich zunächst eine Reihe kleiner Kristallite unterschiedlicher Orientierung, deren Anzahl nach und nach abnahm. Nach etwa 4 cm bestand die Probe über ihren gesamten Querschnitt nur noch aus ausgerichteten Kristalliten. Dieser Bereich wuchs dann weiter bis hinab zum Ende des Stabes. Schliffbilder an verschiedenen Stellen dieses texturierten Bereiches ergaben eindeutig vollständige Textur.

Nach der notwendigen Sauerstoffbehandlung über eine Zeit von 72 h bei einer Temperatur von 450°C wurde aus dem texturierten Teil des Stabes ein Stäbchen mit den Abmessungen 45x2x2 mm herausgeschnitten und mit der üblichen 4-Pkt-Methode vermessen. Dazu wurde das Stäbchen in einen Starkstromgenerator eingespannt, der für eine Stromstärke von 500 A ausgelegt war. Der Strom wurde über die äußeren Enden des Stäbchens eingespeist und die Spannung wurde an zwei 4 cm weit voneinander entfernten Kontakten an dem Stäbchen gemessen. Es ergab sich eine kritische Temperatur $T_c$ von 92 K.

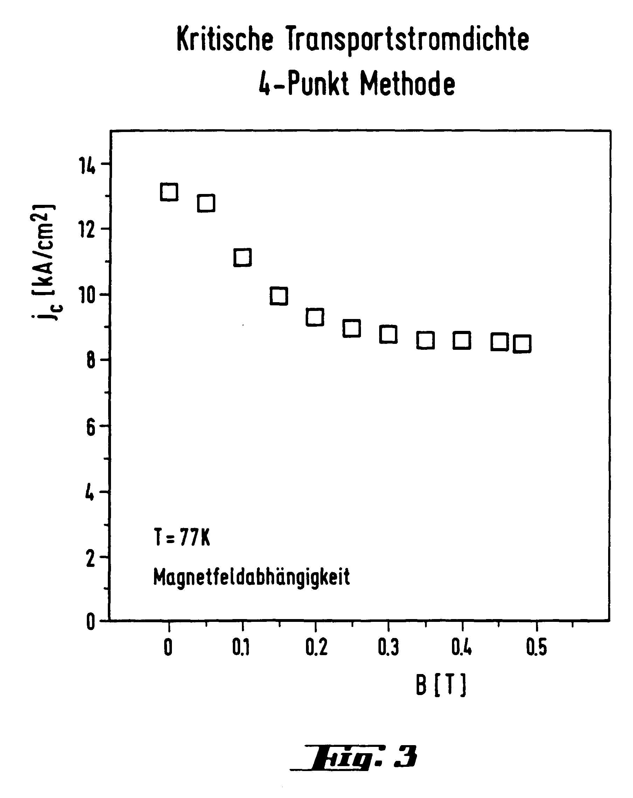

Figur 3 zeigt die Ergebnisse einer Meßreihe der kritischen Transportstromdichte $j_c$ in Abhängigkeit vom Magnetfeld bei T = 77 K. Die kritische Transportstromdichte wurde aus dem Strom errechnet, der einen Spannungsabfall von gerade 1 $\mu$V/cm verursachte. Ohne Magnetfeld wurde eine kritische Transportstromdichte von 13 000 A/cm$^2$ erreicht (Figur 3), bei einem Magnetfeld mit H = 0,5 T senkrecht zur Stromrichtung lag $j_c$ immer noch bei 10 000 A/cm$^2$. Die hohe kritische Transportstromdichte wie auch ihre nur geringe Magnetfeldabhängigkeit zeigen, daß es nach dem erfindungsgemäßen Verfahren möglich ist, eine gleichmäßige Texturierung zu erreichen.

**Beispiel 2:**

Der Rohling wurde zunächst in der gleichen Weise hergestellt wie in Beispiel 1. Vor dem Sintervorgang wurde die gepreßte Probe jedoch angespitzt. Auf ihrer Spitze wurde ein Keim mit der Längsachse seiner Kristallite senkrecht zur Stabachse befestigt und mitgesintert. Damit liegen die c-Achsen der Kristallite des Keims wie gewünscht senkrecht zur Stabachse. Der Keim wurde aus einem Korn eines vorhergehenden Versuches herauspräpariert. Der Temperaturgradient wurde so eingestellt, daß er bezüglich der Stabachse einen Winkel von 35° einnahm, seine waagrechte Komponente war parallel zur c-Achse des Keims. Die Probe wurde nun so in die (schräggestellte) heiße Zone III gebracht, daß der Keim teilweise, aber nicht vollständig, angeschmolzen wurde. Anschließend wurde wie in Beispiel 1 vorgegangen, d.h. die Probe wurde mit einer Geschwindigkeit von 1 mm/h durch die heiße Zone gezogen. Von dem Keim ausgehend kristallisierte die gesamte Probe in der gewünschten Orientierung. Die Probe wurde in analoger Weise wie in Beispiel 1 charakterisiert, allerdings war die kritische Transportstromdichte so hoch, daß sie mit der vorhandenen Ausrüstung nicht bestimmt werden konnte ($j_c$ > 20 000 A/cm$^2$).

**Patentansprüche**

1. Verfahren zur Herstellung von texturierten hochtemperatursupraleitenden massiven Formteilen, dadurch gekennzeichnet, daß massive Formteile aus oxidkeramischem supraleitendem Material eines Phasengemisches der Substanzklasse YBCO zunächst geformt, gepreßt und gesintert werden, daß dann entlang ihrer Längsachse eine zonenweise thermische Behandlung erfolgt, wobei in einer ersten Zone zunächst auf eine Temperatur im Bereich von 50 bis 200 K unterhalb der peritektischen Schmelztemperatur des in dem Formteil vorgegebenen Phasengemisches erhitzt wird, wobei danach in einer zweiten Zone mit einem Temperaturgradienten im Bereich von 10 bis 250 K/cm die Temperatur heraufgesetzt wird, wobei danach in einer dritten Zone eine Temperatur von bis zu 50 K oberhalb der peritektischen Schmelztemperatur des in dem Formteil vorgegebenen Phasengemisches gehalten wird, wobei danach in einer vierten Zone mit einem Temperaturgradienten im Bereich von 10 bis 250 K/cm abgekühlt wird und wobei abschließend in einer fünften Zone eine Temperatur im Bereich von 50 bis 200 K unterhalb der peritektischen Schmelztemperatur des in dem Formteil vorgegebenen Phasengemisches eingehalten wird, und daß die Zonen mit einer Geschwindigkeit im Bereich von 1 bis 10 mm/h in Längsrichtung fortbewegt werden.

2. Verfahren nach Anspruch 1, dadurch gekennzeichnet, daß die Formteile die Geometrie von Stäben mit einem Durchmesser im Bereich von 1 bis 50 mm und einer Länge von bis zu 1 m besitzen.

3. Verfahren nach Anspruch 2, dadurch gekennzeichnet, daß als Ausgangsmaterial für die Stäbe eine Mischung von YBCO 123 mit 12 bis 28 Mol-% YBCO 211, bezogen auf die Gesamtmolmenge an supraleitendem Material, verwendet wird.

4. Verfahren nach Anspruch 3, dadurch gekennzeichnet, daß Zusätze an YBCO 211 in feiner Verteilung von $\leq 1 \mu m$ verwendet werden.

5. Verfahren nach einem der Ansprüche 1 bis 4, dadurch gekennzeichnet, daß dem Ausgangsmaterial für die Formteile zusätzlich $PtO_2$ in einer Menge von 0,5 bis 10 Mol-%, bezogen auf die Gesamtmolmenge an supraleitendem Material, mit einem mittleren Teilchendurchmesser von < 50 $\mu m$ zugesetzt wird.

6. Verfahren nach einem der Ansprüche 1 bis 5, dadurch gekennzeichnet, daß die massiven Formteile vor der zonenweisen thermischen Behandlung zunächst bis zu einer Dichte von 92 % der theoretisch möglichen Dichte gesintert werden.

7. Verfahren nach einem der Ansprüche 1 bis 6, dadurch gekennzeichnet, daß in der vierten Zone ein Temperaturgradient von 50 bis 200 K/cm eingestellt wird.

8. Verfahren nach einem der Ansprüche 1 bis 7, dadurch gekennzeichnet, daß vor der zonenweisen thermischen Behandlung das Formteil an einem Ende angespitzt wird und daß auf der Spitze ein Einkristall in der gewünschten Orientierung befestigt wird.

9. Verfahren nach einem der Ansprüche 1 bis 8, dadurch gekennzeichnet, daß der Temperaturgradient in der vierten Zone in einem Winkel im Bereich von 25° bis 70° schräg zur Längsachse des Formteils gedreht wird.

10. Hochtemperatursupraleitendes massives oxidkeramisches Formteil hergestellt nach einem Verfahren gemäß einem der Ansprüche 1 bis 9, dadurch gekennzeichnet, daß es eine kritische Transportstromdichte $j_c$ von wenigstens 12000 A/cm$^2$ bei einem Spannungsabfall von 1 $\mu V/cm$ ohne Magnetfeld und eine Länge von wenigstens 4 cm aufweist.

11. Hochtemperatursupraleitendes massives oxidkeramisches Formteil hergestellt nach einem Verfahren gemäß einem der Ansprüche 1 bis 9 in der Geometrie von Stäben, dadurch gekennzeichnet, daß es eine kritische Transportstromdichte $j_c$ von wenigstens 12000 A/cm$^2$ bei einem Spannungsabfall von 1 $\mu V/cm$ ohne Magnetfeld und einen Winkel zwischen den c-Achsen der Kristallite und der Stabachse von 55° aufweist.

12. Hochtemperatursupraleitendes massives oxidkeramisches Formteil hergestellt nach einem Verfahren gemäß einem der Ansprüche 1 bis 9 in der Geometrie von Stäben, dadurch gekennzeichnet, daß es eine kritische Transportstromdichte $j_c$ von wenigstens 12000 A/cm$^2$ bei einem Spannungsabfall von 1 $\mu V/cm$ ohne Magnetfeld und einen Winkel zwischen den c-Achsen der Kristallite und der Stabachse von 90° aufweist.

## Claims

1. A process for producing textured high-temperature superconducting massive shaped parts, which comprises massive shaped parts made of oxide-ceramic superconducting material of a phase mixture of the substance class YBCO first being molded, pressed and .sintered, a zonewise thermal treatment then being carried out along their longitudinal axis, heating first being carried out, in a first zone, to a temperature in the range of from 50 to 200 K below the peritectic melting temperature of the phase mixture initially present in the shaped part, the temperature then being raised, in a second zone having a temperature gradient in the range of from 10 to 250 K/cm, then, in a third zone, a temperature of up to 50 K above the peritectic melting temperature of the phase mixture initially present in the shaped part being maintained, cooling then being carried out, in a fourth zone having a temperature gradient in the range of from 10 to 250 K/cm, and finally, in a fifth zone, a temperature in the range of from 50 to 200 K below the peritectic melting temperature of the phase mixture initially present in the shaped part being maintained, and moving the zones along in the longitudinal direction at a speed in the range of from 1 to 10 mm/h.

2. The process as claimed in claim 1, wherein the shaped parts have the geometry of bars having a diameter in the range of from 1 to 50 mm and a length of up to 1 m.

3. The process as claimed in claim 2, wherein the starting material used for the bars is a mixture of YBCO 123 containing from 12 to 28 mol% of YBCO 211, based on the total molar amount of superconducting material.

4. The process as claimed in claim 3, wherein additions of YBCO 211 are used in fine dispersion of $\leq$ 1 μm.

5. The process as claimed in any one of claims 1 to 4, wherein the starting material for the shaped parts is additionally admixed with $PtO_2$ in an amount of from 0.5 to 10 mol%, based on the total molar amount of superconducting material, with a mean particle diameter of < 50 μm.

6. The process as claimed in any one of claims 1 to 5, wherein the massive shaped parts, prior to the zonewise thermal treatment, are first sintered up to a density of 92% of the theoretically possible density.

7. The process as claimed in any one of claims 1 to 6, wherein there is set, in the fourth zone, a temperature gradient of from 50 to 200 K/cm.

8. The process as claimed in any one of claims 1 to 7, wherein, prior to the zonewise thermal treatment, the shaped part is sharpened to a point at one end and there is attached, on the point, a single crystal in the desired orientation.

9. The process as claimed in any one of claims 1 to 8, wherein the temperature gradient in the fourth zone is rotated at an angle in the range of from 25° to 70° obliquely with respect to the longitudinal axis of the shaped part.

10. A high-temperature superconducting massive oxide-ceramic shaped part produced according to a process as claimed in any one of claims 1 to 9, which has a critical transport current density $j_c$ of at least 12,000 $A/cm^2$ for a voltage drop of 1μV/cm without a magnetic field, and a length of at least 4 cm.

11. A high-temperature superconducting massive oxide-ceramic shaped part produced according to a process as claimed in any one of claims 1 to 9 in the geometry of bars, said part having a critical transport current density $j_c$ of at least 12,000 $A/cm^2$ for a voltage drop of 1 μV/cm without magnetic field, and having an angle between the c axes of the crystallites and the bar axis of 55°.

12. A high-temperature superconducting massive oxide-ceramic shaped part produced according to a process as claimed in any one of claims 1 to 9 in the geometry of bars, said part having a critical transport current density $j_c$ of at least 12,000 $A/cm^2$ for a voltage drop of 1 μV/cm without magnetic field, and having an angle between the c axes of the crystallites and the bar axis of 90°.

## Revendications

1. Procédé pour fabriquer des pièces façonnées massives supraconductrices à haute température texturées, caractérisé en ce que des pièces façonnées massives constituées de matière supraconductrice à base d'oxydes céramiques d'un mélange de phases de la classe de substances YBCO sont d'abord façonnées, pressées et frittées, puis il s'ensuit un traitement thermique de zone le long de leur axe longitudinal, au cours duquel on chauffe une première zone à une température dans la plage de 50 à 200 K au-dessous de la température de fusion péritectique du mélange de phases prévu dans la pièce façonnée, ensuite on élève la température dans une deuxième zone avec un gradient de température dans une plage de 10 à 250 K/cm, ensuite on maintient dans une troisième zone une température jusqu'à 50 K supérieure à la température de fusion péritectique du mélange de phases prévu dans la pièce façonnée, ensuite on refroidit dans une quatrième zone avec un gradient de température dans une plage de 10 à 250 K/cm et enfin on maintient dans une cinquième zone une température dans la plage de 50 à 200 K au-dessous de la température de fusion péritectique du mélange de phases prévu dans la pièce façonnée, et en ce que les zones sont déplacées dans le sens de la longueur avec une vitesse comprise entre 1 et 10 mm/h.

2. Procédé selon la revendication 1, caractérisé en ce que les pièces façonnées possèdent la géométrie de barreaux avec un diamètre de 1 jusqu'à 50 mm et une longueur jusqu'à 1 m.

3. Procédé selon la revendication 2, caractérisé en ce que l'on utilise comme matière de départ pour les barreaux, un mélange de YCBO 123 avec 12 à 28% en moles de YBCO 211, par rapport au nombre total de moles de matière supraconductrice.

4. Procédé selon la revendication 3, caractérisé en ce que l'on utilise des additifs au YBCO 211 sous forme de division fine $\leq$ 1μm.

5. Procédé selon l'une quelconque des revendications 1 à 4, caractérisé en ce qu'il est ajouté en plus à la matière de départ pour les pièces façonnées du

$PtO_2$ à raison de 0,5 à 10% en moles, par rapport au nombre total de moles de matière supraconductrice, avec un diamètre moyen de particules < 50 µm.

6. Procédé selon l'une quelconque des revendications 1 à 5, caractérisé en ce que les pièces façonnées massives sont d'abord frittées jusqu'à une densité de 92% de la densité théorique possible avant le traitement thermique de zone.

7. Procédé selon l'une quelconque des revendications 1 à 6, caractérisé en ce que l'on établit dans la quatrième zone un gradient de température de 50 à 200 K/cm.

8. Procédé selon l'une quelconque des revendications 1 à 7, caractérisé en ce que l'on aiguise la pièce façonnée à une extrémité avant le traitement thermique de zone et que l'on fixe sur la pointe un monocristal dans l'orientation souhaitée.

9. Procédé selon l'une quelconque des revendications 1 à 8, caractérisé en ce que le gradient de température dans la quatrième zone est tourné d'un angle oblique de 25° à 70° par rapport à l'axe longitudinal de la pièce façonnée.

10. Pièce façonnée massive supraconductrice à haute température à base d'oxydes céramiques produite par un procédé selon l'une quelconque des revendications 1 à 9, caractérisée en ce qu'elle présente une densité de courant de transport critique $j_c$ d'au moins 12 000 A/cm$^2$ pour une chute de tension de 1 µV/cm en absence de champ magnétique et une longueur d'au moins 4 cm.

11. Pièce façonnée massive supraconductrice à haute température à base d'oxydes céramiques produite par un procédé selon l'une quelconque des revendications 1 à 9 dans la géométrie de barreaux, caractérisée en ce qu'elle présente une densité de courant de transport critique $j_c$ d'au moins 12 000 A/cm$^2$ pour une chute de tension de 1 µV/cm en absence de champ magnétique et un angle de 55° entre les axes c des cristallites et l'axe du barreau.

12. Pièce façonnée massive supraconductrice à haute température à base d'oxydes céramiques produite par un procédé selon l'une quelconque des revendications 1 à 9 dans la géométrie de barreaux, caractérisée en ce qu'elle présente une densité de courant de transport critique $j_c$ d'au moins 12 000 A/cm$^2$ pour une chute de tension de 1 µV/cm en absence de champ magnétique et un angle de 90° entre les axes c des cristallites et l'axe du barreau.

## Fig. 1

# Kristallitorientierung

**Fig. 2**

## Kritische Transportstromdichte
## 4-Punkt Methode

**Fig. 3**